**Europäisches Patentamt**

**European Patent Office**

**Office européen des brevets**

(19)

(11) Publication number: **0 090 280**
A2

(12) **EUROPEAN PATENT APPLICATION**

(21) Application number: **83102660.4**

(22) Date of filing: **17.03.83**

(51) Int. Cl.³: **H 01 L 27/02, H 01 L 21/82**

(30) Priority: **25.03.82 JP 47769/82**
**30.08.82 JP 149113/82**
**31.08.82 JP 149858/82**

(43) Date of publication of application: **05.10.83**
**Bulletin 83/40**

(84) Designated Contracting States: **DE FR GB**

(71) Applicant: **NISSAN MOTOR COMPANY, LIMITED, No.2, Takara-cho, Kanagawa-ku, Yokohama City (JP)**

(72) Inventor: **Mihara, Teruyoshi, 13-305m Nissan Tateno Apartment House 16-1, Futaba, Yokosuka City Kanagawa-ken (JP)**
Inventor: **Murakami, Koichi Nissan-Uragou-ryou, No. 3-68, Higashi-cho Oppama, Yokosuka City Kanagawa-ken (JP)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22 (DE)**

(54) **Semiconductor integrated circuit device and method of making the same.**

(57) In a semiconductor integrated circuit device, a vertical type MOS FET is formed in a semiconductor substrate in such a manner that the semiconductor substrate constitutes the drain region thereof, the vertical type MOS FET being connected to a load for switching on and off a current flowing through the load; a first lateral type MOS FET is formed in the drain region of the vertical type MOS FET and connected to protect the latter from an excessive current which tends to flow when the load is shortcircuited; and a second lateral type MOS FET is also formed in the drain region of the vertical type MOS FET and used as an element in a detection-control circuit for controlling the first lateral type MOS FET by detecting the shirt-circuit of the load.

## BACKGROUND OF THE INVENTION

### FIELD OF THE INVENTION

This invention relates to a semiconductor switch circuit device wherein a current flowing through a load is switched by means of a power MOS transistor. More particularly, the invention pertains to such a semiconductor switch circuit device adapted, when the load is shorted out, to protect the power MOS transistor by interrupting the current flowing therethrough, and a method of manufacturing such a device.

### DESCRIPTION OF THE PRIOR ART

In view of the demand that drive circuit for the foregoing type of switch circuit be simplified and provided in the form of integrated circuit as well as the demand that such a circuit be able to be operated with a lower power source voltage, it is the recent trend to employ, as a switching element, a power MOS transistor, especially a vertical type power MOS transistor with a lower "on" resistance.

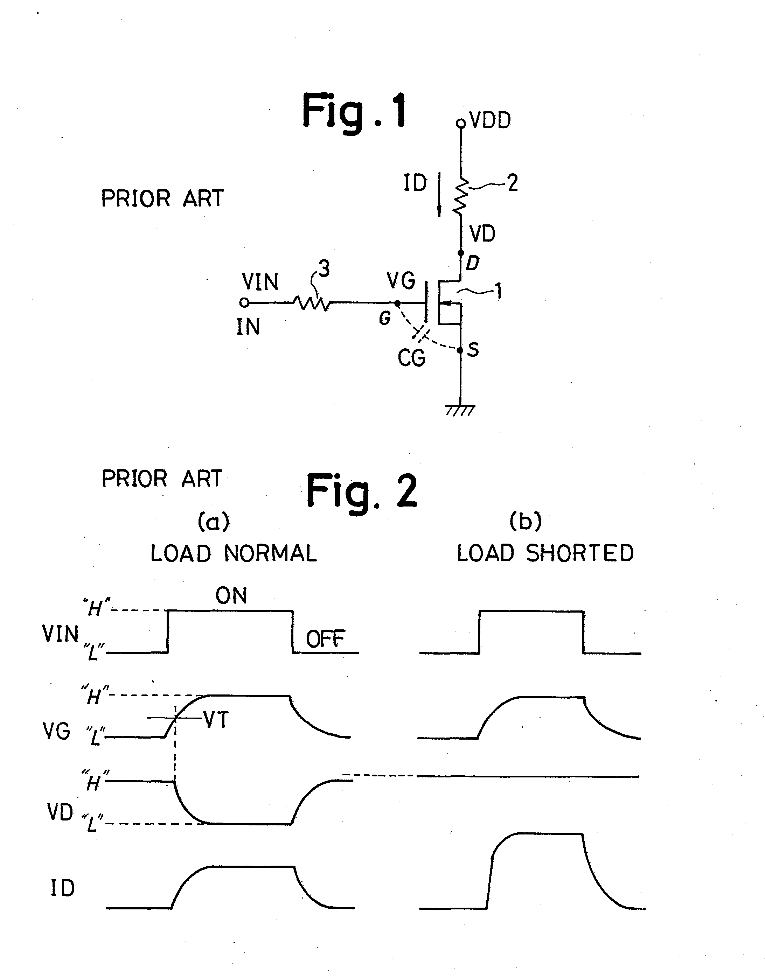

In order to have a better understanding of the present invention, reference will first be made to Figures 1 to 4 of the accompanying drawings.

Referring to Figure 1, there is shown a conventional

1

semiconductor switch circuit using an ordinary power MOS transistor. Figures 2(a) and (b) are timing charts useful for explaining the operation of the conventional switch circuit.

In the semiconductor switch circuit shown in Figure 1, the power MOS transistor, indicated at 1, has the source S thereof grounded, the drain D thereof connected to a load 2, and the gate G thereof connected to an input terminal IN through a resistor 3.

The foregoing conventional circuit arrangement is advantageous in that the switching current is extremely low, by virtue of the fact that the pwer MOS transistor is essentially of a voltage-operated type so that the on-off operation thereof can be performed simply by supplying thereto a current low enough to charge the gate capacitance CG thereof.

The aforementioned conventional switch circuit arrangement has another advantage that a satisfactory chattering preventing function is realized, without using any special chattering preventing circuit, by an integrator circuit which is constituted by the resistor 3 and gate capacitance CG.

As will be appreciated, with the above-mentioned conventional switch circuit arrangement, in the case where the load 2 is in a normal or non-shorted state, power dissipation P, which is determined from product of the drain voltage VD and drain current ID, is kept sufficiently below a maximum allowable limit Pmax when the gate voltage VG reaches a "High" level (referred to as "H" hereinafter), as shown in Figure 2(a). In the case where the load 2 is short-circuited, however when the gate voltage VG reaches the "H", the drain voltage VD is increased, and thus the drain current ID is also increased greatly as shown in Figure 2(b), so that the power dissipation P is increased to such an extent that the power MOS transistor 1 tends to be damaged.

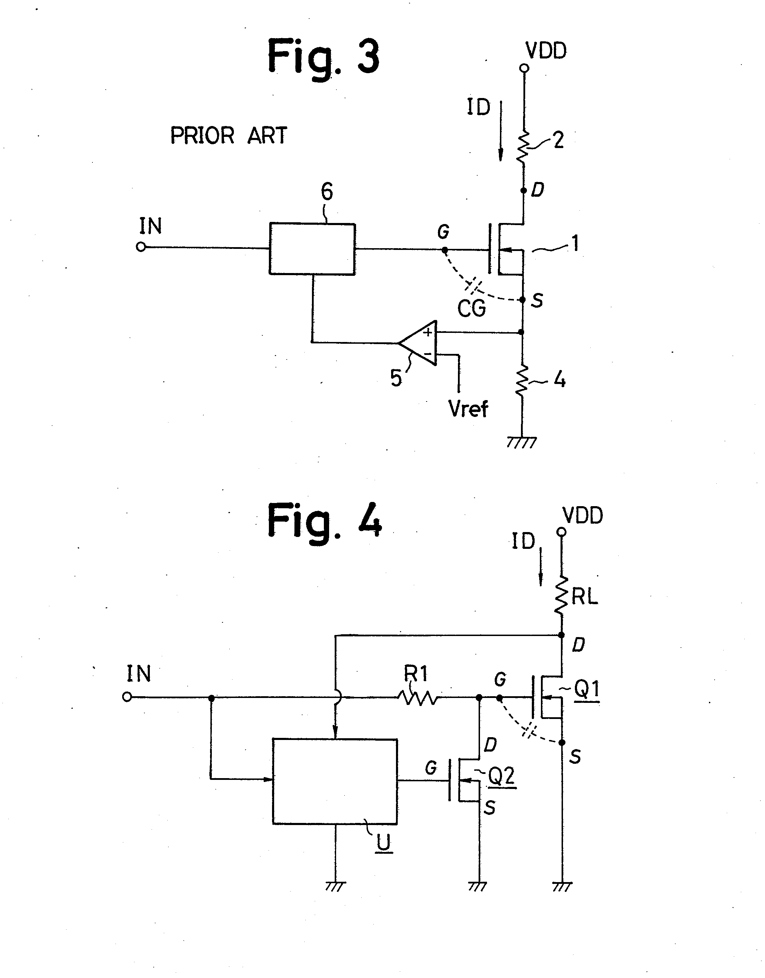

In an attempt to avoid the problem mentioned above, there has conventionally been proposed such a circuit arrangement as shown in Figure 3, wherein a change in the drain current ID of a power MOS transistor 1 is converted to a voltage to be detected, by means of a resistor 4 of a low value which is connected in series with the source S of the MOS transistor 1; the voltage thus detected is compared with a predetermined reference voltage Vref in a comparator 5; and a signal resulting from the comparison is imparted to activate a drive circuit 6, which is connected between the gate G of the MOS transistor 1 and an input terminal IN, so that when a load is short-circuited, the voltage at the gate G is focibly decreased down to a "Low" level (referred to as "L" hereinafter), thereby protecting the power MOS transistor 1.

However, the conventional circuit arrangement shown in Figure 3 has such a problem that the fact that power is wastefully dissipated in the resistor 4 all the time, constitutes a hindrance to reduction of power dissipation in the entire switch circuit arrangement. Another problem is such that the low resistance occupies a relatively large area when integrated on a semiconductor substrate, thus hindering attainment of a high-density integrated circuit.

In the case where as the power MOS transistor 1, use is made of a vertical type power MOS transistor with a low "on" resistance and the entire circuit arrangement is built in a single semiconductor substrate in the form of an integrated circuit, then the substrate serves as the drain of the vertical power MOS transistor so that the substrate potential is hardly stabilized; hence it is required that insulating layers be additionally provided in order that the remaining circuit units such as comparator 5, drive circuit 6 and so forth can be incorporated, in the form of integrated circuit, in the same semiconductor substrate. To cope with this, use of external components, which are disadvantageous in terms of cost, should be resorted to.

SUMMARY OF THE INVENTION

Accordingly, it is an object of the present invention to provide a semiconductor switch circuit device including protective circuit means which is so designed as to minimize switch driving current and power dissipation and can be constructed in the form of integrated circuit, thereby solving the aforementioned problems with the prior art.

Briefly, to achieve the foregoing object, according to the present invention, there is provided a semiconductor switch circuit device comprising a first transistor constituted by a vertical type power MOS transistor for switching a load; a second transistor constituted by a lateral type MOS FET having the drain thereof connected to the gate of the first transistor; and means for detecting whether the load is short-circuited or not and adapted, when the load is shorted out, to apply between the gate and the source of the second transistor a voltage for rendering the second transistor conductive between the drain and the source thereof, thereby causing the first transistor to be turned on, the aforementioned detecting means including a third transistor constituted by a lateral type MOS FET similar to the second transistor and/or a resistor constituted by a lateral type MOS FET, the third transistor and/or resistor being formed in the first transistor's drain region which is adapted to serve as a substrate therefor.

Other objects, features and advantages of the present invention will become apparent from the ensuing description taken in conjunction with the accompanying drawings.

BRIEF DESCRIPTION OF THE DRAWINGS

Figure 1 is a circuit diagram showing a conventional switch circuit device using a power MOS FET.

Figures 2(a) and (b) are timing charts useful for explaining the operation of the conventional switch circuit device shown in Figure 1, when the load is non-shorted and when the load is shorted, respectively.

Figure 3 is a circuit diagram showing another conventional power MOS FET type switch circuit provided with a protective circuit arrangement.

Figure 4 is a basic circuit diagram of the semiconductor switch circuit device according to the present invention.

Figure 5 is a sectional view showing integrated-circuit construction of the semiconductor switch circuit device according to the present invention.

Figure 6 is a circuit diagram of the switch circuit device according to a first embodiment of the present invention.

Figures 7(A) and (b) are timing charts useful for explaining the operation of the circuit shown in Figure 6, when the load is non-shorted and when the load is shorted, respectively.

Figure 8 is a sectional view showing integrated-circuit construction of a detection-control circuit unit incorporated in the circuit shown in Figure 6.

Figure 9 is a circuit diagram of the semiconductor switch circuit device according to a second embodiment of the present invention.

Figures 10(a) and (b) are timing charts useful for explaining the operation of the circuit shown in Figure 9, when the load is non-shorted and when the load is shorted, respectively.

Figure 11 is a circuit diagram of the semiconductor switch circuit device according to a third embodiment of the present invention.

Figures 12(a) and (b) are timing charts useful for explaining the operation of the circuit shown in Figure 11, when the load is non-shorted and when the load is shorted, respectively.

Figure 13 is a circuit diagram showing, in further detail, the arrangement shown in Figure 11.

Figure 14 is a view useful for explaining a process of manufacturing the semiconductor switch circuit device according to the present invention.

## DESCRIPTION OF THE PREFERRED EMBODIMENTS

Referring to Figure 4, there is shown a basic circuit arrangement for the semiconductor switch circuit device embodying the present invention, which comprises a transistor Q1 constituted by an n-channel type vertical MOS FET having the source grounded; a transistor Q2 constituted by an n-channel type lateral MOS FET having the drain thereof connected to the gate of the transistor Q1; and a detection-control circuit U for providing a control signal to the gate G of the transistor Q2. A load RL is connected to the drain D of the transistor Q1 the gate of which is supplied with an input signal VIN from an input terminal IN through a resistor Rl. The detection-control circuit U, which is supplied with input signals from the input terminal IN and from the drain D of the transistor Q1, is arranged to detect the drain potential of the transistor Q1 when the load RL is shorted out, and upon detection, impart a control voltage between the gate and the source of the transistor Q2, thereby rendering the transistor Q2 conductive between the drain and the source thereof. As a result, the gate potential of the transistor Q1 is decreased so that the transistor Q1 is rendered non-conductive.

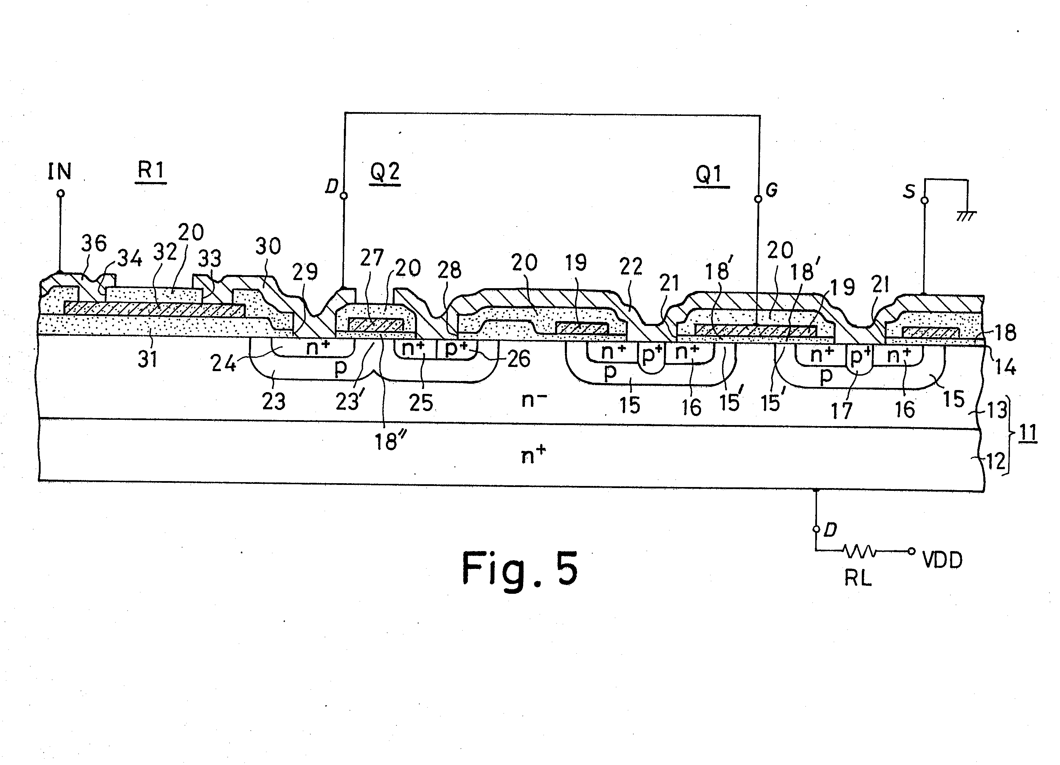

Figure 5 illustrates the construction of the present semiconductor switch circuit device which is provided in the form of integrated circuit, wherein only the transistors Q1, Q2 and resistor R1 are shown for the sake of convenience. In Figure 5, indicated at 11 is an n type silicon substrate which includes a high concentration n type semiconductor layer 12 and a low concentration n type semiconductor region 13 formed therein. Formed in the semiconductor region 13 is a ring-like p type semiconductor region 15 which is exposed at a main surface 14 of the substrate 11; and formed in the p type semiconductor region 15 are a high concentration n type semiconductor region 16 and low concentration p type semiconductor region 17 which are also exposed at the main surface 14 of the substrate 11 and arranged in a ring-like form and in concentric relationship with the semiconductor region 15. An insulating thin layer 18 of silicon dioxide is provided on the main surface 14, and a conductor layer 19 of polycrystalline silicon is provided on portions 18' of the thin layer 18 which are disposed in contact with the semiconductor region 15. Furthermore, an insulating layer 20 of phosphorus glass is provided covering the insulating thin layer 18 and conductor layer 19. A conductor layer 22 formed by a vapor-deposited aluminum film is provided on the insulating layer 20 and connected to the semiconductor regions 16 and 17 through windows 21 which are formed through the insulating layer 20 and insulating thin layer 18.

In this way, the transistor Q1 is constructed in the form of a vertical type n-channel MOS FET which comprises a drain electrode formed by the $n^+$ semiconductor layer 12; a drain region formed by the $n^-$ semiconductor region 13; a channel forming region formed by that portion 15' of the p type semiconductor region 15 which is adjacent the main surface 14; a source region formed by the $n^+$ semiconductor region 16; a source electrode formed by the conductor layer 22; a gate insulating film formed by the insulating thin layer portion 18'; and a gate electrode formed by the conductor layer 19. With such a construction, a drain current ID is permitted to flow from the semiconductor region 13 to the semiconductor region 16 through a channel which is formed in the channel forming region 15'.

Furthermore, formed in the semiconductor region 13 is a $p^+$ type semiconductor region 23 which is exposed at the main surface 14 of the substrate 11, and formed in the region 23 are high concentration n type semiconductor regions 24 and 25 which are exposed at the main surface 14 and disposed in laterally spaced and juxtaposed relationship with each other. Formed in the semiconductor region 23 is a high concentration p type semiconductor region 26 which is disposed adjacent the region 25 and exposed at the main surface 14. A conductor layer 27 of polycrystalline silicon is provided on that portion 18" of the aforementioned insulating thin layer 18 which is provided on the region between the portions 24 and 25 of the semiconductor region 23. Insulating layer 20 of phosphorus glass covers the conductor layer 27 and insulating thin layer 18. The conductor layer 22 adapted to serve as the source electrode of the transistor Q1 as mentioned above is provided extending over the insulating layer 20 and connected to the conductor layers 25 and 26 through windows 28 which are formed through the insulating layers 20 and 18. A conductor layer 30 formed by a vapor-deposited aluminum film is provided on the insulating layer 20, and it is connected to the semiconductor region 24 through a window 19 which is also formed through the insulating layers 20 and 18.

In this way, formed in the semiconductor region or p well 23 is the second transistor Q2 which is constituted by a lateral type n-channel MOS FET comprising a drain region formed by the $n^+$ type semiconductor region 24; a source region formed by the $n^+$ type semiconductor region 25; a channel forming region formed by that portion 23' of the p type semiconductor region 23 which is disposed between the semiconductor regions 24 and 25 and adjacent the main surface 14;
a gate insulator film formed by the insulating thin
layer portion 18"; and a drain electrode and source
electrode formed by the conductor layers 30 and 22
respectively.

On the main surface 14 of the substrate 11,
except for the areas in which the transistors Q1 and
Q2 are formed, there is also provided a thick insulating layer 31 of silicon dioxide on which a conductor
layer 32 of polycrystalline silicon is provided which
is adapted to serve as a resistor layer. The conductor
layer 30 serving as the drain electrode of the transistor
Q2 and another conductor layer 36 are connected to the
conductor layer 32 and thus to each other therethrough
and through windows 33 and 34 which are formed through
the insulating layer 20 at the opposite ends of the
conductor layer 32. The resistor R1 is constituted
by the conductor layer 32, and the input terminal IN
is led out of the conductor layer 36 which is connected
to that end portion of the resistor R1 which is remote
from the transistor Q2. The $p^+$ type semiconductor
regions 17 and 26 serve as contact regions for grounding
the p type semiconductor regions 15 and 23, respectively.

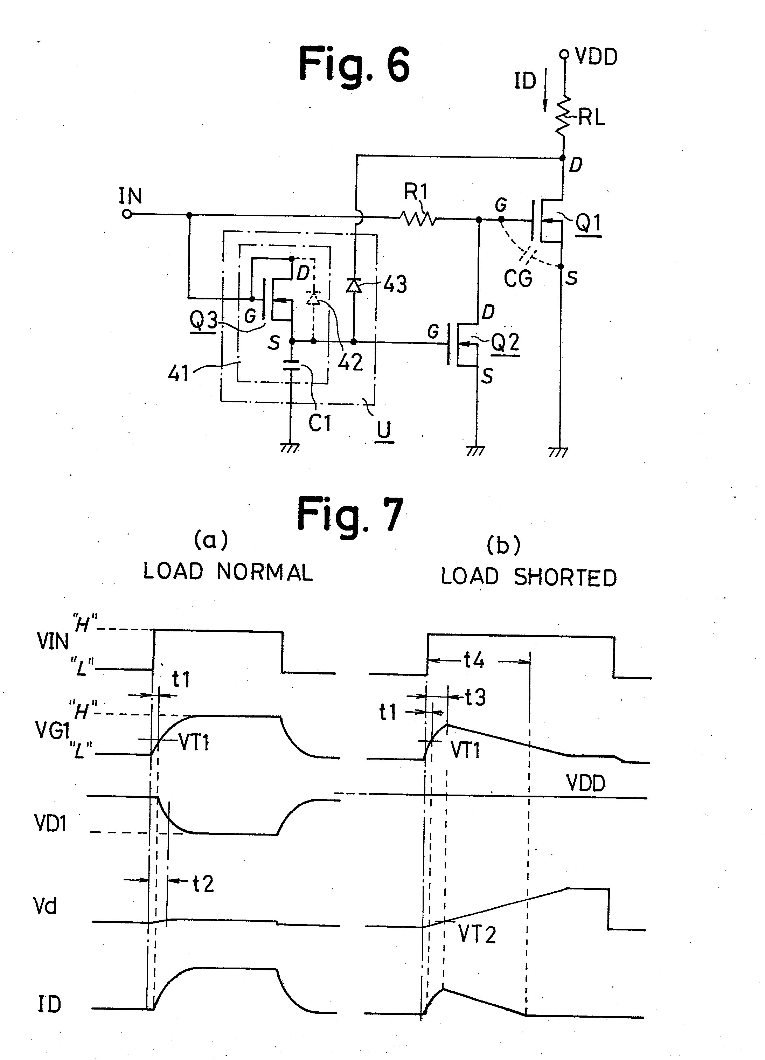

Referring to Figure 6, there is illustrated a circuit
diagram of the semiconductor switch circuit device according to a first embodiment of the present invention.

The circuit shown in Figure 6 includes an n-channel type vertical power MOS transistor Ql having the source S thereof grounded, the drain D thereof connected to a power source VDD through a load RL, and the gate G thereof connected to an input terminal IN through a resistor Rl.

With the foregoing circuit arrangement, when voltage VIN at the input terminal IN momentarily changes either from "L" to "H" or from "H" to "L", voltage at the gate G of the transistor Ql either builds up or drops down following a time-constant curve defined by the resistor Rl and gate capacitance CG, so that the transistor Ql will finally be turned on or off, thereby switching current ID flowing through the load RL.

The circuit shown in Figure 6 also includes a protective n-channel type lateral MOS transistor Q2 having the source S thereof grounded and the drain thereof connected to the gate of the transistor Ql.

Thus, when the gate voltage VG of the transistor Q2 reaches the threshold voltage VT2 thereof, the transistor Q2 will be turned on so that the potential at the gate G of the transistor Ql will be dropped down to ground potential.

The detection-control circuit U includes an integrator type delay circuit 41 provided between the input terminal IN and ground, the delay circuit 41 being comprised of a series connection of a MOS resistor R2 constituted by an n-channel type MOS FET Q3, and a capacitor C1; and a discharging diode 41 which exists as a parasitic diode and is connected between the source S and the drain D of the n-channel MOS transistor (MOS resistor) Q3 forwardly as viewed from the source S toward the drain D.

Especially in this example, the transistor Q3 is adapted to serve as a constant current source by virtue of the fact that the MOS resistor is constituted by the n-channel type MOS transistor with the gate G and drain D thereof being shorted together.

Thus, if the potential VIN at the input terminal IN builds up momentarily from "L" to "H", then the capacitor C1 will be charged with a constant current in accordance with the current characteristic of the MOS resistor, so that potential VS3 at the source S of the transistor Q3, i.e., at the terminal input of the delay circuit 41 will linearly build up with a predetermined small inclination angle.

If the potential VIN at the input terminal IN drops down momentarily from "H" to "L", on the other hand, the charge at the capacitor C1 will rapidly be discharged through the discharging diode 42, so that the output of the delay circuit 41 will momentarily fall.

Furthermore, a short-circuit detecting diode 43 is connected between the source S (serving as the output terminal of the delay circuit 41) and the drain D of the transistor Q3 forwardly as viewed from the source S of the transistor Q3 toward the drain D of the transistor Q1. The output voltage Vd of the delay circuit is applied to the gate G of the transistor Q2.

Thus, the output voltage Vd of the delay circuit 41, which is applied to the gate G of the transistor Q2, is clamped by the diode 43, with the drain voltage $VD1$ of the transistor Q1 as reference.

Description will now be made of the operation of the aforementioned semiconductor switch circuit device with reference to the timing charts shown in Figures 7(a) and (b), when the load is non-shorted and when the load is shorted.

Figure 7(a) is the timing chart when the load is non-shorted. As will be seen from this timing chart, when the input voltage VIN rises up from "L" to "H" to turn on the transistor Q1, the gate voltage $VG1$ of the transistor Q1 begins to build up slowly with a time constant ($=CG \cdot Rl$) which is determined by the resistor R1 and the gate capacitance CG of the transistor Q1.

Subsequently, when the gate voltage $VG1$ of the

transistor Q1 goes above the threshold voltage VT1 thereof after a lapse of time t1 from the point of time when the input voltage VIN rises up, the transistor Q1 is turned on so that drain current ID begins to flow through the load RL, and at the same time the drain voltage VD1 of the transistor Q1 begins to drop down.

The output voltage Vd of the deley circuit 41, which is constituted by the transistor Q3 and capacitor C1, builds up in response to the rising-up of the input voltage VIN, more slowly than the gate voltage VG1 of the transistor Q1.

Thus, before the output voltage Vd of the delay circuit 41 becomes equal to the threshold voltage VT2 of the transistor Q2, that is, at a point of time when time t2 elapses from the point of time when the input voltage VIN rises up, the drain voltage VD1 of the transistor Q1 goes below the threshold voltage VT2 of the transistor Q2, as a result of which the output voltage Vd of the delay circuit 41 is clamped to VD1 + VF, where VF is the forward voltage drop across the diode 43.

Let it be assumed that the forward voltage drop VF of the diode 43 is 0.6V and that the drain voltage VD1 of the transistor Q1 when the latter is completely turned on, is 0.4 V. Then, the threshold voltage VT2

16

of the transistor Q2 should be set as follows:

$$VT2 \geq 0.6V + 0.4V = 1V$$

By setting the threshold voltage VT2 of the transistor Q2 as mentioned above, the output voltage Vd of the delay circuit 41 is always limited below the threshold voltage VT2 of the transistor Q2, in so far as the load RL is in the normal or non-shorted state; thus, the gate voltage VG1 of the transistor Q1 is maintained at the "H" level, so that the drain current ID continues flowing.

When the input voltage VIN is caused to fall from "H" to "L" to turn off the transistor Q1, the charge at the gate capacitance CG of the transistor Q1 is discharged through the resistor R1, and at a point of time when VG1 < VT1, the transistor Q1 is fully turned off so that the drain current ID is no longer permitted to flow.

The charge at the capacitor Cl is also rapidly discharged through the diode 42, and thus the output voltage Vd of the delay circuit 41 drops down to a level equal to the forward voltage drop VF (about 0.6V) of the diode 43.

Needless to say, if the situation that the input voltage VIN = 0 V persists, then the output voltage Vd of the delay circuit 41 will also drop down to 0 V at last, so that the delay circuit 41 will be reset.

In case the next "H" level arrives at the input terminal IN before the output voltage of the delay circuit 41 drops down to 0 V, the delay time turns out slightly shorter, but no problem will arise if a sufficiently large time constant is established in the delay circuit 41.

As will be appreciated from the above discussion, when the load RL is in the normal or non-shorted state, the transistor Q1 is enabled to perform the normal switching operation as the input voltage VIN changes from "H" to "L" and vice versa.

In case the load RL is cut off, the drain current ID is no longer permitted to flow, and that is all. In such a case, since the rain voltage VD1 = 0 V, the output voltage Vd of the delay circuit 41 is clamped to VF (about 0.6 V), so that the transistor Q2 is kept in the "off" state as in the case where the load is normal or non-shorted.

Figure 7(B) is the timing chart when the load is shorted. In this figure, when the input voltage VIN rises up from "L" to "H" to turn on the transistor Q1, the gate voltage VG1 of the transistor Q1 begins to build up following the predetermined time-constant curve as in the case where the load is non-shorted, and at a point of time when time t1 elapses and VG1 = VT1, the transistor Q1 is turned on so that the drain current ID thereof begins to flow.

Since the load RL is shorted out, the power source voltage VDD is applied, as it is, to the drain D of the transistor Q1; thus, the drain voltage VD1 of the transistor Q1 is maintained at VDD.

At this time, the output voltage Vd of the delay circuit 41 also begins to build up gradually, in response to the rising-up of the input voltage VIN, but since even after the transistor Q1 has been turned on, the drain voltage VD1 thereof is maintained at the power source voltage VDD, the output voltage Vd of the delay circuit 41 further continues building up, unlike in the case where the load is non-shorted; thus, after a lapse of time t3, the output voltage Vd goes above the threshold voltage VT2 of the transistor Q2.

In this way, the transistor Q2 is turned on so that the gate voltage VG1 of the transistor Q1 begins to drop, as a result of which the drain current ID thereof also begins to decrease gradually. At a point of time when time t4 elapses and VG1 < Vt1, the drain current ID is no longer permitted to flow.

Thus, the drain current ID is only permitted to flow for a very short period of time (t4 - t1). By virtue of this feature, it is possible to prevent the switching element from being damaged due to power dissipation.

The periods of time t1, t2 and t4 can be set as desired, by suitably selecting the gate width/gate length of the MOS transistor Q3, the value of the capacitor C1 and the value of the resistor R1.

In case the input voltage VIN falls from "H" to "L", then the charge at the capacitor C1 is rapidly discharged through the diode 42 so that the delay circuit 41 is reset.

In case the load is suddenly shorted out when the load is normal and the transistor Q1 is conducting, the output voltage Vd of the delay circuit 41 is immediately caused to begin building up from the level to which it has so far been clamped in Figure 7(a), and after a lapse of a short period of time, the output voltage Vd goes above the threshold voltage VT2 of the transistor Q2 as shown in Figure 7(b), so that the gate voltage VG1 of the transistor Q1 is decreased and thus the drain current ID thereof is interrupted, as shown in Figure 7(b).

As will be appreciated from the above explanation, with the protective circuit arrangement according to this embodiment, since shorting-out of the load is detected on the basis of the drain voltage VD1 of the transistor Q1, unlike the prior art in which such detection is effected on the basis of variation in the load current which is taken out by means of a resistor of a low value connected to the source of the transistor Q1, it is possible to avoid wasteful power dissipation which would otherwise be caused in the resistor while the transistor Q1 is conducting.

Furthermore, according to this embodiment, by virtue of the fact that the discharge diode 42 exists as a parasitic diode in parallel with the MOS transistor Q3 employed for the delay circuit 41, the output voltage Vd of the delay circuit 41 is immediately caused to be "L" when the input voltage falls from "H" to "L" and thus even if "H" is repeatedly supplied to the input terminal IN with short intervals, it is less likely that irregularities are caused in the delay time characteristic of the delay circuit 41. Still furthermore, by virtue of the fact that the MOS transistor having the drain and gate shorted together is employed as the resistor for the delay circuit 41, the output voltage Vd of the delay circuit 41 is caused to linearly build up as a function of time; thus, as comparted with the case where a simple linear resistor is used, it is easier to set the delay time characteristic as desired, and yet it is possible to construct the delay circuit with higher precision.

According to this embodiment, as mentioned above, the n-channel type power MOS FET having the source thereof grounded is used as the power switching element;

the n-channel MOS transistor is employed as the protective transistor; and the serises connection of the MOS transistor and capacitor is used to constitute the delay circuit of the detection-control circuit U. Thus, a vertical type power MOS transistor, which is employed as the power switching element, can readily be provided, in the form of integrated circuit, in a semiconductor substrate without providing any special isolation means. Furthermore, since the resistor connected to the gate of the power transistor may be of a relatively large value, the area which is occupied by the resistor may be smaller, so that higher density inegration can be achieved.

As will be appreciated from the foregoing discussion, according to the present invention, in a semiconductor switching device including a vertical type MOS power transistor connected in series with a load for the purpose of switching a drive circuit for the load, components of a protective circuit for the vertical type MOS transistor can be provided in the form of integrated circuit in the same substrate as the vertical type power MOS transistor, and use of a resistor for detecting short-circuit of the load can be eliminated, thus avoiding wasteful power dissipation which otherwise inevitably occurs. Furthermore, by virtue of the feature that the time delay from a point of time when a switching signal is inputted to the gate of the power MOS transistor to a point of time when a load side terminal voltage is detected, is established by utilizing the gate capacitance of the power MOS transistor, it is possible to eliminate the necessity to provide separate capacitors as circuit elements; thus, no extra areas are needed so that miniaturization of the device is facilitated. Still furthermore, by virtue of the feature that externally inputted switching signal is employed as power source for the aforementioned protective circuit, it is also possible to eliminate the necessity to provide a separate power source for the protective circuit; thus, the circuit arrangement of the present device is simplified.

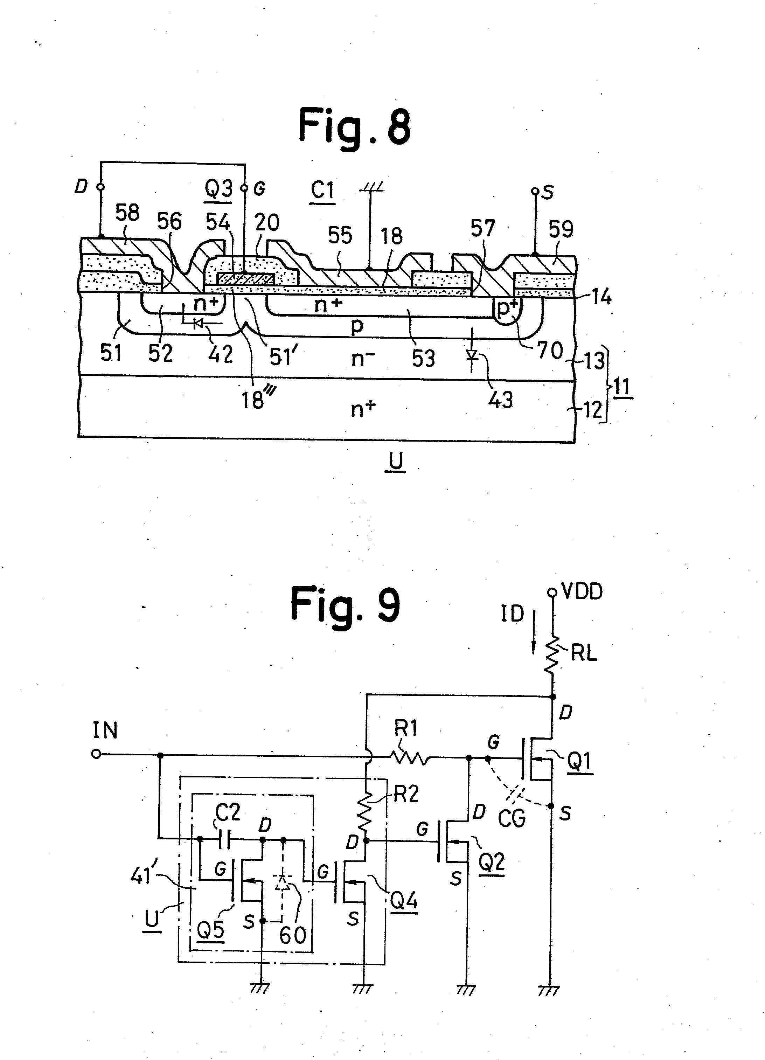

Referring to Figure 8, there is shown, in a sectional view, integrated-circuit construction of the detection-control circuit U incorporated in the semiconductor switch device according to the first embodiment of the present invention, wherein the MOS transistor Q3 is provided in a semiconductor region or p well 51 which is formed in the $n^-$ type drain region 13 of the transistor Q1 and exposed at the main surface 14 of the substrate 11. More specifically, $n^+$ type semiconductor regions 52 and 53 are formed in the semiconductor region or p well 51 in such a manner as to be exposed at the main surface 14 and in laterally spaced and juxtaposed relationship with each other; the semiconductor region 53 is extended laterally over a relatively large length; a $p^+$ type semiconductor region 70 is formed in the p well 51, in contact with the semiconductor region 53 at the end thereof remote from the semiconductor region 52; a conductor layer 54 of polycrystalline silicon is provided on that portion 18"' of the insulating thin layer 18 on the main surface 14 which exists between the regions 52 and 53; the conductor layer 54 and part of the insulating thin layer 18 are covered with the insulating layer 20 of phosphorus glass; the semiconductor region 53 is partially covered with the insulating thin layer 18 on which a conductor layer 55 formed by a vapor-deposited aluminum film is provided in such a manner as to extend partially over the insulating layer 20; a window 56 is formed through those portions of the insulating layers 20 and 18 which overlie the region 52; a window 57 is formed through those portions of the insulating layers 20 and 18 which overlie the regions 53 and 54; and conductor layers 58 and 59 are coupled to the semiconctor regions 52 and 53, 70 through the windows 56 and 57.

In this way, the transistor Q3 is constructed which is constituted by a lateral type   MOS FET having a drain region formed by the $n^+$ type semiconductor region 52; a source region formed by the $n^+$ type semiconductor region 53; a channel forming region formed by that portion 15' of the p type semiconductor region 51 which is adjacent the main surface 14 between the region 52 and 53; a gate insulating film formed by the insulating thin layer portion 18"'; a gate electrode formed by the conductor layer 54; and a drain electrode and source electrode formed by the conductor layers 58 and 59 respectively. The capacitor Cl is constituted by the $n^+$ type semiconductor region 53, insulating thin layer 18 and conductor layer 55. Diode 42 is formed by the pn junction between the p type semiconductor region 51 and the $n^+$ type semiconductor region 52, and another diode 43 is constituted by the pn junction between the p type semiconductor region 51 and the $n^+$ type semiconductor region 13. The gate and drain electrodes of the transistor Q3 are connected together through suitable means and the drain electrode is connected to the input terminal IN.

With the arrangement shown in Figures 5, 6 and 8, by virtue of the fact that the transistor Q1 is constituted by the vertical type power MOS FET, it is possible to cause a current to flow thickness-wise of the substrate 11, thereby greatly decreasing the "on" resistance of the transistor Q1. Thus, the

semiconductor switch circuit device embodying the present invention is advantageously applicable for power switching purposes. In addition to this major advantage, according to the present invention, the following advantage can also be attained: By virtue of the feature that the respective protective circuit components are completely isolated from the drain region of the transistor Q1 by the p type semiconductor regions 23 and 51 formed in the drain region 13, it is possible to achieve stabilized protective circuit operation, irrespective of variations in the drain current, without providing any special insulating layer.

Furthermore, with the aforementioned construction, by virtue of the feature that the discharging diode 42 and load short-circuit detecting diode 43 are constituted by parasitic diodes formed between the p type semiconductor region 51 and the drain region 13 and betweeen the drain region 52 and the p type semiconductor region 51 respectively, it is possible to eliminate the necessity that diode portions be separately formed in the semiconductor substrate, and also by virtue of the feature that the resistor R1 may be of a relatively large value, it is possible to miniaturize the area which is occupied by this resistor, thus achieving high-density integration.

Figure 9 is a circuit diagram of the semiconductor switch device according to a second embodiment of the present invention, which includes a vertical type n-channel power MOS transistor Q1 for switching on and off a current flowing through a load RL; a MOS transistor Q2 having the drain thereof connected to the gate of the transistor Q1 and the source thereof grounded; and an input resistor R1 connected between the gate of the transistor Q1 and an input terminal IN to which a switching control signal VIN is applied. The device also includes a detection-control circuit U which comprises a feedback resistor R2 connected between the drain of the MOS transistor Q1 and the base of the MOS transistor Q2; a MOS transistor Q4 having the drain thereof connected to the base of the MOS transistor Q2 and the source thereof grounded; and a MOS transistor Q5 having the drain thereof connected to the input terminal IN through a capacitor C2 and the source thereof grounded, wherein a differentiator type delay circuit 41' is constituted by the MOS transistor Q5 and capacitor C2. The delay time of the delay circuit 41' can be determined by suitably selecting the ratio of gate length to gate width of the MOS transistor Q5 and the area of the capacitor C2. Indicated at 60 is a parasitic diode formed between the source and the drain of the MOS transistor Q5.

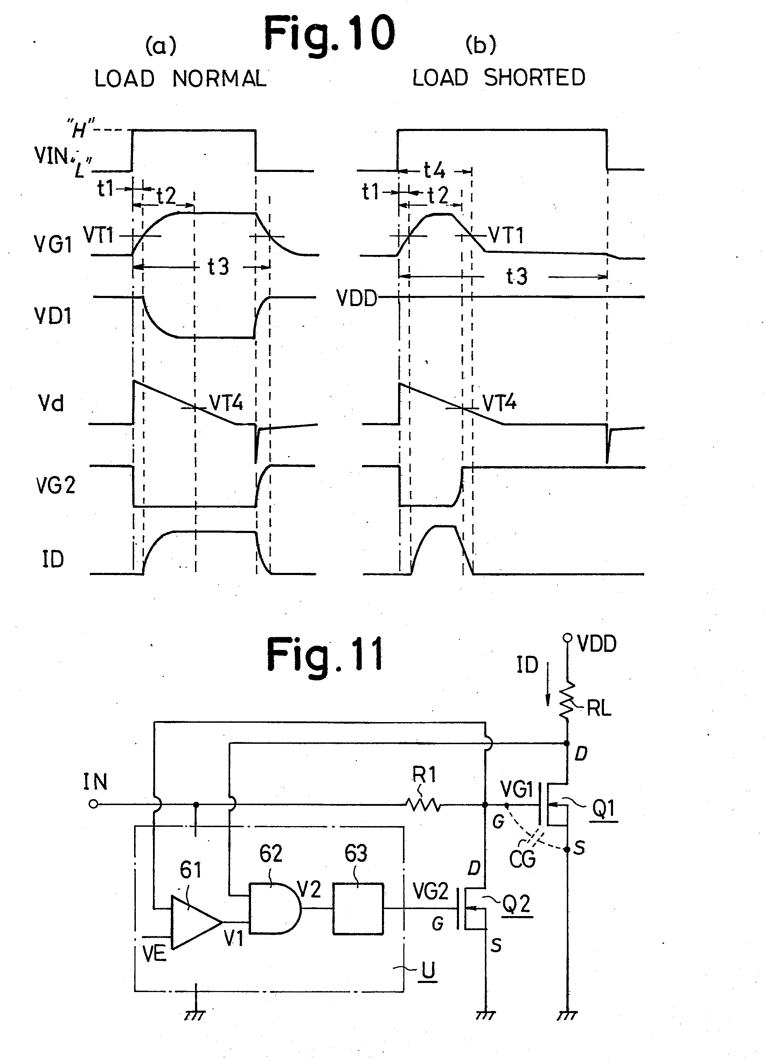

From the timing chart of Figure 10(a) which illustrates the operation of the present device when the load is normal or non-shorted, it will be seen that when the switching control signal VIN rises up to "H", the gate voltage VG1 of the power MOS transistor Q1 builds up slowly in accordance with a time constant determined by the input resistor R1 and the gate capacitance CG of the MOS transistor Q1.

After a lapse of time t1 from the point of time when the switching control signal VIN rises up, the gate voltage VG1 goes above the threshold voltage VT1 of the MOS transistor Q1 so that the latter is turned on and thus a drain current ID begins to flow therethrough, and at the same time, due to a voltage drop across the load RL, the drain voltage VD1 of the MOS transistor Q1 begins to drop. When the gate voltage VG1 becomes a steady state, i.e., fully rises up, the drain voltage VD1 becomes a full "L" state.

As the switching control signal VIN rises up, the output Vd of the differentiator type delay circuit 41' constituted by the MOS transistor Q5 and capacitor C2 builds up slowly and then drops down linearly. The time constant with which the output voltage Vd of the delay circuit 41' drops down is selected to be greater than the time constant determined by the input resistor

R1 and the gate capacitance CG of the MOS transistor Q1; thus, even when the MOS transistor Q1 has become fully conductive, the output voltage Vd still continues dropping. The MOS transistor Q4 is rendered conductive concurrently with the inputting of the switching control signal, and the "on" resistance thereof is much lower than the value of the feedback resistor R2, so that the output voltage Vd is permitted to drop down to a value close to the threshold voltage VT4 of the MOS transistor Q4, thus pulling the gate voltage VG2 of the MOS transistor Q2 below the threshold voltage thereof until time t2 elapses. In this way, the MOS transistor Q2 is fully conducting until time t2 elapses from the point of time when the switching control signal rises up.

After a lapse of time t2, the output voltage Vd goes below the threshold voltage VT4 of the transistor Q4 so that the latter is rendered non-conductive, and thus voltage VG2 = VD1 is imparted to the gate of the MOS transistor Q3. In this case, since the drain voltage VD1 is at "L" level when the load RL is normal or non-shorted, as mentioned above, the transistor Q2 is not turned on, and thus the gate voltage VG1 of the MOS transistor Q1 is maintained at the "H" level so that load current ID is permitted to continue flowing.

In order to interrupt the load current ID, the switching control signal VIN is made to be "L". If the switching control signal VIN is not made to be "L" (= 0 V), then the charge at the gate capacitance CG of the MOS transistor Q1 will be discharged through the input resistor R1, and thus at a point of time when the gate voltage VG1 of the MOS transistor Q1 goes below the threshold voltage thereof, the MOS transistor Q1 will fully be rendered non-conductive, thus resulting in the load current ID being interrupted. At this time, the charge stored at the capacitor C2 will also be discharged rapidly through the parasitic diode 60 of the transistor Q5, so that the output voltage Vd of the delay circuit 41' will be made to be of a negative value which is equal in magnitude to the forward voltage drop (VF = 0.6 V) of the parasitic diode 60, and thus the delay circuit 41' will be reset.

From the timing chart of Figure 10(b) which illustrates the operation of the present device when the load is shorted, it will be seen that the drain voltage VD1 of the MOS transistor Q1 is equal to the power source voltage VDD, or the "H" level when the load is shorted. If the switching control signal VIN rises up from "L" to "H" when the load is shorted, then the gate voltage VG1 of the MOS transistor Q1 will build up so that load current begins to flow temporarily, as in the case where the load is normal

0090280

or non-shorted, but the drain voltage VD1 of the MOS transistor Q1 will be maintained at VDD since the load RL is shorted.

The output voltage Vd of the delay circuit 41' will rise up concurrently with the inputting of switching control signal VIN and subsequently drops down gradually as in the case where the load is normal or non-shorted. After a lapse of time t2 from the point of time when the switching control signal was inputted, the output voltage Vd will go below the threshold voltage VT4 of the MOS transistor Q4 so that the latter will rendered non-conductive, and thereupon the drain voltage VD1 of the MOS transistor Q1, or the power source voltage VDD will be applied to the gate of the MOS transistor Q2 so that the latter will rapidly be turned on. As a result, the charge stored at the gate capacitance CG of the MOS transistor Q1 will be discharged and thus the gate voltage VG1 of the MOS transistor Q1 will be decreased. When the gate voltage VG1 goes below the threshold voltage VT1 after a lapse of time t4 from the point of time when the switching signal VIN was inputted, the MOS transistor Q1 will fully be turned off so that the load current ID will no longer be permitted to flow. As will be appreciated, the load current ID is only

31

permitted to flow for a short period of time, or (t4 - tl) from the point of time when the switching control signal rose up, and thus the switching element is prevented from being damaged by power dissipation, unlike in the case of the prior art.

When the switching control signal VIN is changed from "H" to "L", as in the case where the load is normal or non-shorted, the charge at the capacitor C2 will be discharged through the parasitic diode 60 so that the delay circuit 41' comprised of the MOS transistor Q5 and capacitor C2 will be reset. Further, the charge stored at the gate capacitance CG of the MOS transistor Ql will also be fully dis-charged through the MOS transistor Q2 and input resistor R2.

In integrated-circuit construction of the detection-control circuit U shown in Figure 9, the transistor Q4 may be similar to the transistor Q2 shown in Figure 5; and the transistor Q5 and capacitor C2 may be similar to the transistor Q3 and capacitor C2 shown in Figure 8, respectively, and therefore illustration and description thereof will be omitted.

Referring to Figure 11, there is shown a circuit diagram of the semiconductor switch circuit device according to a third embodiment of the present invention, which comprises a vertical type n-channel MOS

transistor Q1 for switching on and off a current flowing through a load RL; a protective MOS transistor Q2 having the drain thereof connected to the gate of the MOS transistor Q1 and the source thereof grounded; a resistor R1 connected between an input terminal IN for a switching signal VIN and the connection point between the gate of the MOS transistor Q1 and the drain of the protective MOS transistor Q2; and a detection-control circuit U. According to this embodiment, the detection-control circuit U comprises a comparator 61 for comparing the gate voltage VG1 of the MOS transistor Q1 with a reference voltage VE (for example, a voltage that makes it possible to discriminate whether or not the gate voltage VG1 becomes substantially equal to the switching signal VIN) to provide a "High" level (referred to as "H" level hereinafter) signal V1 when $VG1 > VE$; an AND circuit 62 for making logical product between the drain voltage VD1 of the MOS transistor Q1 and the output signal V1 of the comparator 61; and a latch circuit 63 for holding the output V2 of the AND circuit 62 when the output V2 becomes "H" level, wherein output voltage VG2 of the latch circuit 63 is applied to the gate of the protective MOS transistor Q2.

Description will now be made of the operation

33

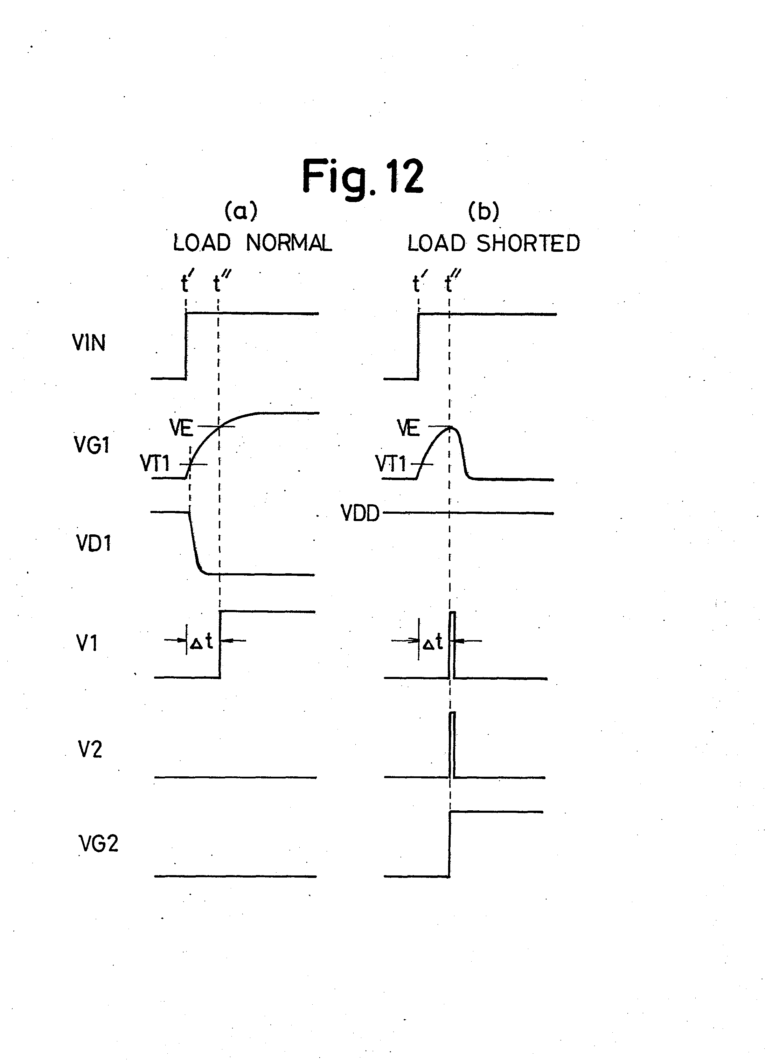

of the semiconductor switch circuit device according
to the third embodiment of the present invention,
with reference to Figures 12(a) and (b).

In the semiconductor switch circuit device
mentioned just above, the MOS transistor Q1 is turned
on or off by detecting whether the drain voltage VD1
of the MOS transistor Q1 is a "L" lever or "H" level,
after switching signal VIN is inputted.   In the case
where the load RL is a resistive one such as lamp,
for example, a certain period of time (100 µs or less,
for example) is taken before the drain voltage VD1
of the transistor Q1 builds up sufficiently (up to
1 V or less, for example) after the switching signal
VIN has been inputted.   It is required, therefore,
that measurement of the drain voltage VD1 be carried
out after a lapse of a predetermined period of time
from the point of time when the switching control
signal VIN was inputted.

Figure 12(a) is a timing chart useful for explaining the operation of the foregoing third
embodiment when the load is normal or non-shorted.
Let it be assumed that switching signal VIN is
inputted at a point of time t'.  Then, the gate voltage
VG1 of the MOS transistor Q1 will build up gradually
in accordance with a time constant which is determined
by the resistor R1 and the gate capacitance of the
transistor Q1.  When the gate voltage VG1 reaches the

threshold voltage VT1 of the transistor Q1, the latter will be turned on so that the drain voltage VD1 thereof will begin to drop. At a point of time t", the drain voltage VD1 will become equal to the reference voltage VE of the comparator 61, and thereupon the output signal V1 of the comparator 61 will become "H" level. Time interval or time delay Δt between the points of time t' and t" can be changed as desired, by suitable adjusting the value of the resistor R1 and the reference voltage VE. With such time delay, it is possible to cause generation of the signal V1 by the comparator 61 to be delayed until the drain voltage VD1 is sufficiently decreased. In case the drain voltage VD1, immediately after the switching signal VIN has been inputted, is at "H" level, the output signal V1 of the comparator will be at "L" level, and only when the output signal V1 becomes "H" level, the drain voltage VD1 will become "L" level. In such a case, AND condition is never established in the AND circuit 62, so that the output V2 of the AND circuit is always at "L" level. Consequently, the output VG2 of the latch circuit 63 is also at "L" level all the time. Thus, the protective MOS transistor Q2 is in "off" state, and the gate voltage VG1 of the transistor Q1 is maintained at "H" level so that the transistor Q1 continues

conducting.

Figure 12(b) is a timing chart useful for explaining the operation of the third embodiment when the load is short-circuited.

When the load is shorted, the drain voltage VD1 of the transistor Q1 is equal to the power source voltage VDD, i.e., at "H" level. In such a state, if switching signal VIN is inputted at a point of time t', then the gate voltage VG1 of the transistor Q1 will begin to build up as in the case where the load is normal or non-shorted. When the gate voltage VG1 of the transistor Q1 reaches the threshold voltage VT1 thereof, the transistor Q1 will be rendered conductive, and when the gate voltage VG1 exceeds the reference voltage VE of the comparator 61, the output signal V1 of the comparator 61 becomes "H" level. Meanwhile, the time delay Δt from the point of time when the switching signal VIN is inputted to the point of time when the output signal V1 is outputted, is the same as in the case where the load is normal or non-shorted. Thus, the output V2 of the AND circuit 62 becomes "H" level; the output VG2 of the latch circuit 63 becomes "H" level; and the protective transistor Q2 is turned on. When the transistor Q2 is turned on, the gate voltage VG1 of the transistor Q1 becomes "L" level, so that the transistor Q1 is rendered non-

conductive, thus interrupting the load current ID. When the gate voltage VG1 of the transistor Q1 becomes "L" level, the output signal V1 of the comparator 61 and the output V2 of the AND circuit 62 also become "L" level, while the output VG2 of the latch circuit 63 is maintained at "H" level. In this way, when the load is shorted out, the transistor Q1 is turned off so as to be prevented from being damaged by an excessive current.

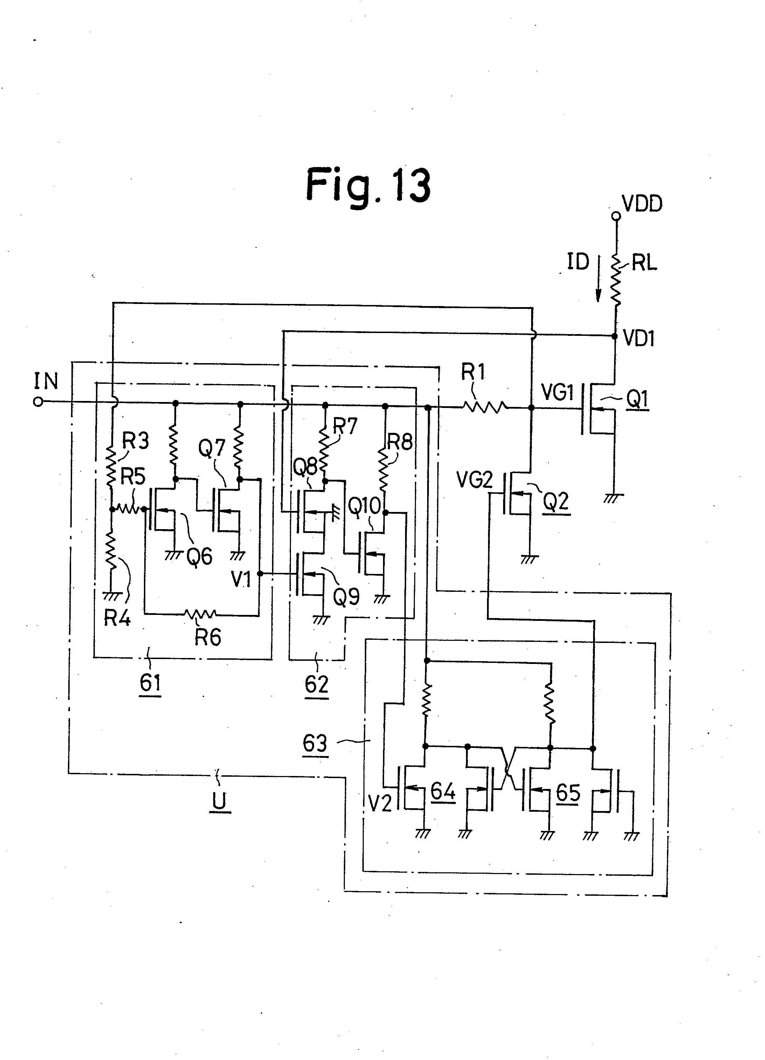

Figure 13 is a circuit diagram illustrating a practical version of the circuit shown in Figure 11, which is realized in view of the condition that the substrate is made to serve as the drain of the power MOS transistor in order for the present device to be integrated in the same chip as the power MOS transistor. In Figure 13, parts corresponding to those of Figure 11 are indicated by like reference numerals.

In the circuit arrangement of Figure 13, the comparator 61 is constituted by a so-called Schmidt circuit which comprises two MOS transistors Q6 and Q7, wherein the gate voltage VG6 of the MOS transistor Q6 is obtained by dividing the gate voltage VG1 of the MOS transistor Q1 by means of resistors R3 to R6; and when VG1 = VE, the gate voltage VG6 becomes equal to the threshold voltage of the MOS transistor Q6. The AND circuit 62 comprises three MOS transistors Q8, Q9 and Q10, and two resistors R7, R8; and the latch circuit 63 comprises two NAND circuits 64 and 65 which are connected together through feedback.

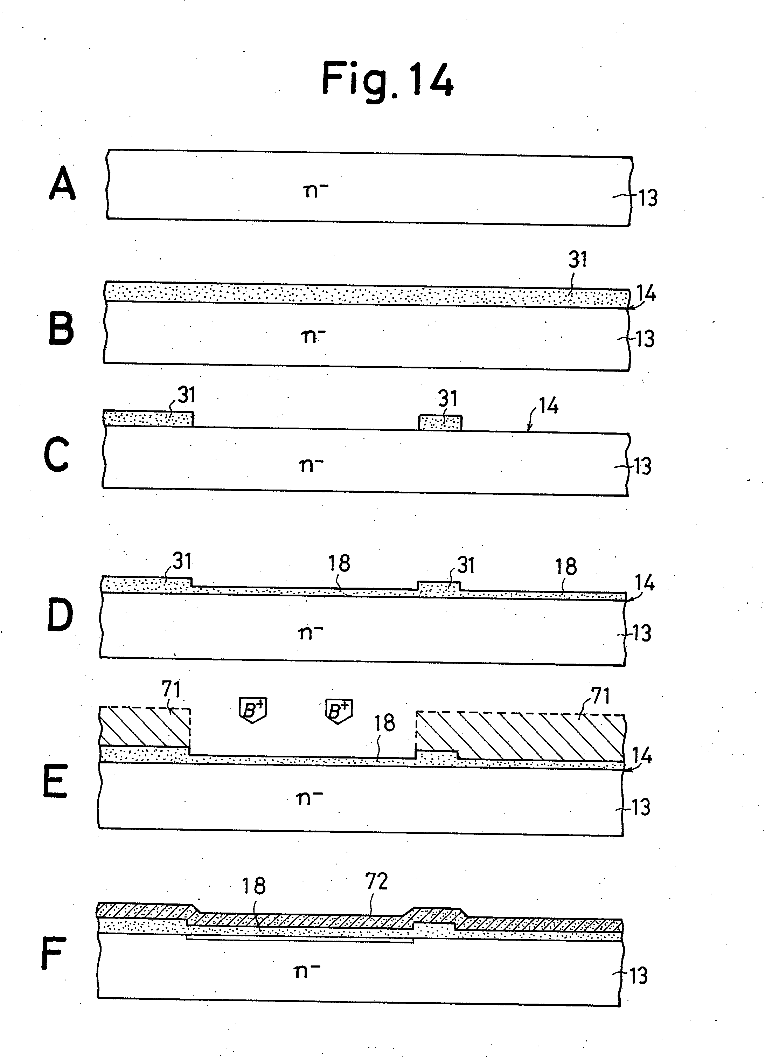

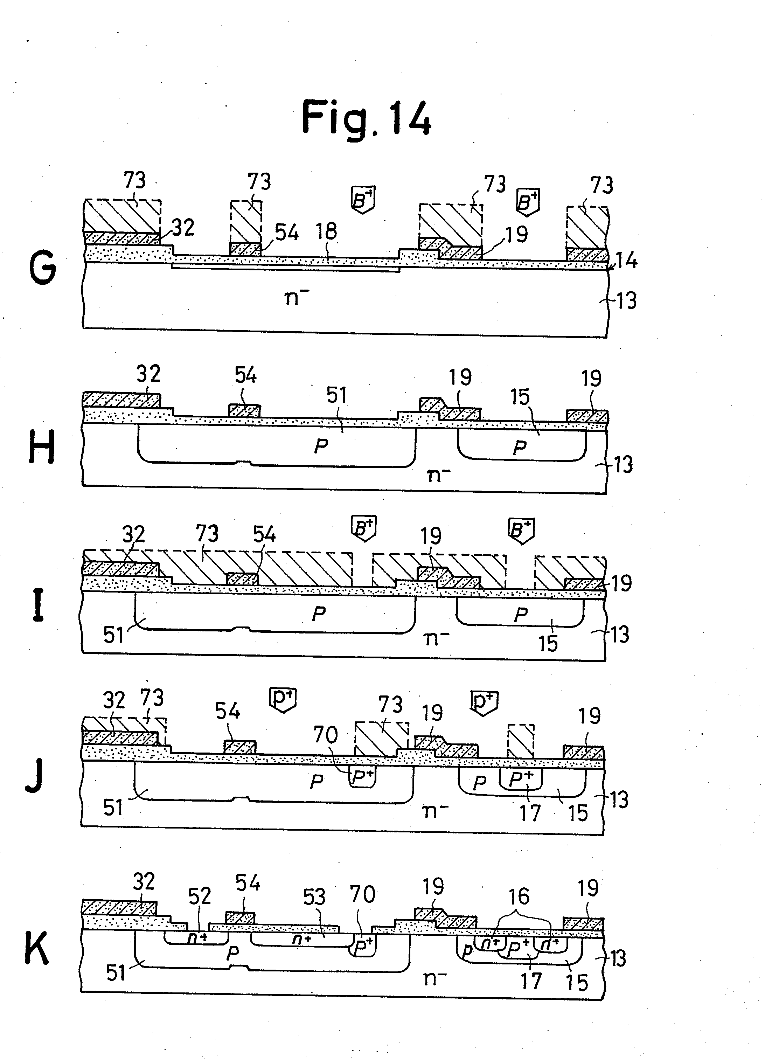

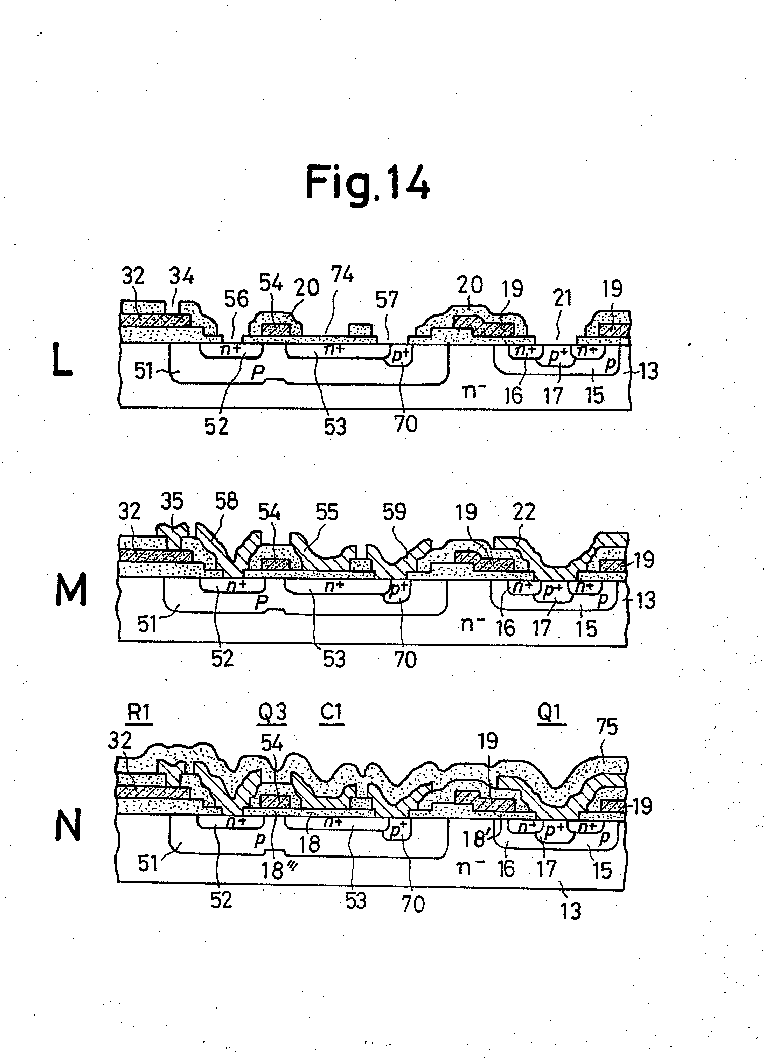

Reference will now be made to Figure 14 which illustrates an example of the process of manufacturing the present semiconductor switch circuit device in the form of integrated circuit, wherein the transistor Q1 and resistor R1 shown in Figure 5 and the transistor Q3 and capacitor C1 constituting the detection-control circuit U according to the first embodiment of the present invention are shown, and the transistor Q2 and remaining ones are not shown since the process of fabricating such transistors is similar to that of making the transistor Q3. In Figure 14, parts corresponding to those of Figures 5 and 8 are indicated by like reference numerals.

First of all, as shown in Figure 14A, a silicon wafer constituting semiconductor region 13 is provided which is formed by $n^+$ type silicon substrate having $n^-$ type epitaxial layer gown thereon. The resistivity of the wafer may be selected depending on the withstand voltage of the transistor Q1. In the case where such withstand voltage should be as high as 200 V, for example, the resistivity of the wafer is selected to be 6 $\Omega$-cm.

A relatively thick insulating layer 31 of silicon

dioxide ($SiO_2$) is grown on the main surface 14 of the semiconductor region 13 by means of the conventional thermal oxidation technique, as shown in Figure 14B. The growth condition for $SiO_2$ is set to be 500 $\overset{0}{A}$ in a wet atmosphere at $1000^{\circ}C$.

Subsequently, the insulating layer 31 is etched out at areas in which respective transistors are to be formed, by means of the conventional photoetching technique, so that the main surface 14 is exposed at those areas, as shown in Figure 14C.

Insulating thin layer 18 of silicon dioxide ($SiO_2$) is grown on the exposed areas of the main surface 14 by means of oxidation, as shown in Figure 14D. In this case, the layer 18 is grown to be 1000 $\overset{0}{A}$ in a dry atmosphere of $O_2$ at $1050^{\circ}C$. Thereafter, as shown in Figure 14E, the insulating layers 18 and 31, except for the area in which the transistor $Q_3$ is to be formed, is covered with resist as indicated at 71, and subsequently, with the resist layer 71 as a mask, boron ions are selectively implanted into the area : for forming the transistor Q3, through the insulating thin layer 18. In this case, the quantity of boron ions to be implanted is selected depending on the threshold voltage VT3 of the transistor Q3. Assuming that the threshold voltage VT3 of the transistor Q3 is VT3 = 1.5 ∿ 2V, and that the depth of diffusion of p well 51 (Figure 14H) is 4 μm, for example, the quantity of boron ions to be implanted is $1 \sim 2 \times 10^{13}/cm^2$, and acceleration energy for the implantation is 100 KeV, for example.

Then, the resist 71 is removed, and subsequently conductor layer 72 of polycrystalline silicon is formed entirely on the insulating layers 18 and 31, by means of low-pressure chemical vapor deposition (LPCVD), as shown in Figure 14F. The conductor layer 72 thus formed is 6000 $\overset{0}{A}$ in thickness and 10 $K\Omega/cm^2$ in sheet resistance, for example. At this time, doping is concurrently effected in a quantity corresponding to the resistance value of the resistor R1.

As shown in Figure 14G, the conductor layer 72 is etched out by means of the conventional photoethcing technique, leaving conductor layer 19 adapted to serve as the gate electrode of the transistor Q1; conductor layer 54 adapted to serve as the gate electrode of the transistor Q3; and conductor layer 32 adapted to serve the resistor R1. Subsquently, resist is applied, as indicated at 73, onto the conductor layers 19, 32 and 54, and then, with the resist 73 as a mask, boron ions are implanted into both of the regions in which the transistors Q1 and Q3 are to be formed. Assuming that the threshold voltage of the transistor Q1 is 1 v, and that the depth of diffusion of p well (Figure 14H)

is 3 μm, for example, the quantity of boron ions to be implanted is $0.5 \sim 1 \times 10^{13}/cm^2$, and acceleration energy for the implantation is 100 KeV.

The boron ions implanted as described above with reference to Figures 14E and G, are subjected to diffusion in a nitrogen gas atmosphere at $1200^\circ C$ for five hours, whereby p type semiconductor regions 15 and 51 are formed, as shown in Figure 14H.

Subsequently, as shown in Figure 14I, resist 73 is applied, except for contact portions for the p type regions 15 and 51, and with the resist 73 as a mask, boron ions are implanted into the contact portions through the insulating layer 18. The quantity of boron ions to be implanted is $1 \times 10^{15}/cm^2$, and acceleration energy for the implantation is 100 KeV.

The boron ions implanted as mentioned above are subjected to diffusion in an atmosphere on $N_2$, whereby well contact regions 17 and 70 are formed, as shown in Figure 14J. Thereafter, resist is applied as indicated at 73, and with the resist 73 and conductor layers 19, 54 as masks, phosphorus ions are implanted, through the insulating layer 18, to form the source region of the transistor Q1, and the drain and source regions of the transistor Q3. The quantity of phosphorus ions to be implanted is $1 \times 10^{15}/cm^2$, and acceleration energy for the implantation is 100 KeV.

The phosphorus ions thus implanted are subjected to diffusion in an atmosphere of $N_2$, whereby the source region 16 of the transistor Q1, and the drain region 52 and source region 53 of the transistor Q3 are formed, as shown in Figure 14K. Subsequently, the insulating layer 18 is etched out at contact regions for the drain 52 and source 53. The depth of diffusion of the regions 16, 52 and 53 is made to be 1 μm through heating at $1050^{\circ}$ for 30 minutes.

Thereafter, as shown in Figure 14L, insulating layer 20 of phosphorus glass (PSG) is deposited on the entire surface, by means of chemical vapor deposition, covering the conductor layers 19 and 54 which are adapted to constitute the gate electrodes of the transistors Q1 and Q3 respectively, and then windows 21, 34, 56, 57 and 74 are formed through the insulating layer 20, by means of etching, at portions where electrode and wiring layers are to be formed of aluminum, as shown in Figure 14L.

Aluminum is vapor-deposited onto the entire surface; and the resultant aluminum layer is etched out to form electrode, wiring and conductor layers 22, 35, 55, 58 and 59, as shown in Figure 14M. The composite structure is annealed in an atmosphere of $N_2$ at $450^{\circ}$ for 30 minutes, for example.

Finally, for the purpose of achieving surface stabilization, the electrode and wiring layers are covered with insulating layer 75 of phosphorus glass, as shown in Figure 14N, and then the insulating layer 75 is etched out at portions overlying the input terminal for switching signal VIN and earth terminal taking out portion (pad), through not shown.

In this way, the semiconductor switch circuit device of the present invention is provided in the form of integrated circuit.

As will be appreciated from the above discussion, integrated-circuit construction of the semiconductor switch circuit device according to the present invention can be realized simply by including one additional step in the conventional process of manufacturing a vertical type power MOS transistor. This means that the construction of the present invention is advantageous in terms of mass production and cost.

Although, in the foregoing, description has been made of the case where all the MOS transistors are of the n-channel type, the present invention is equally applicable in the case where the MOS transistors are of the p-channel type.

While the present invention has been described and illustrated in connection with specific embodiments thereof, it is to be understood that the present invention is by no means limited thereto but covers all changes and modifications within the scope of the appended claims.

What is claimed is:

1.    A semiconductor integrated circuit device, comprising:

a vertical type MOS FET formed in a semiconductor substrate in such a manner that the semiconductor substrate constitutes the drain region thereof, said vertical type MOS FET being connected to a load for switching on and off a current flowing through said load;

a first lateral MOS FET formed in the drain region of said vertical type MOS FET, said first lateral type MOS FET being connected to said vertical type MOS FET to protect the latter from an excessive current which tends to flow when said load is short-circuited; and

a second lateral type MOS FET formed in the drain region of said vertical type MOS FET, said second lateral type MOS FET being adapted to be used as an element in a detection-control circuit for controlling said first lateral type MOS FET by detecting the short-circuit of said load.

2.    A semiconductor integrated circuit device according to claim 1, wherein:

said vertical type MOS FET has the drain thereof connected to said load, the source thereof grounded and the gate thereof connected to a switching control signal input terminal through a first resistor, said first lateral type MOS FET having the drain thereof connected to the gate of said vertical type MOS FET and the source thereof grounded, said second lateral type MOS FET having the drain and the gate thereof connected together and to said input terminal and the source thereof connected to the gate of said first lateral type MOS FET; and

said detection-control circuit comprises said second lateral type MOS FET, a first capacitor connected between the source of said second lateral type MOS FET and ground, and a diode having the cathode thereof connected to the drain of said vertical type MOS FET and the anode thereof connected to the source of said second lateral MOS FET.

3. A semiconductor integrated circuit device according to claim 2, wherein:

said second lateral type MOS FET has the channel forming region thereof and the source thereof connected together;

said first capacitor is constituted by an insulating thin layer provided on the source region of said second lateral type MOS FET, and a conductor layer provided on said insulating thin layer; and

said diode is constituted by a pn junction between the channel forming region of said second lateral type MOS FET and said semiconductor substrate.

4. A semiconductor integrated circuit device according to claim 1, further comprising a third lateral type MOS FET formed in the drain of said vertical type MOS FET, wherein:

said vertical type MOS FET has the drain thereof connected to said load, the source thereof grounded and the gate thereof connected to a switching control signal input terminal through a first resistor, said first lateral type MOS FET having the drain thereof connected to the gate of said vertical type MOS FET and the source grounded, said second lateral type MOS FET having the drain thereof connected to the gate of said first lateral type MOS FET and the source thereof grounded, said third lateral type MOS FET having the drain thereof connected to the gate of said second lateral type MOS FET, the gate thereof connected to said input terminal and the source thereof grounded; and

said detection-control circuit comprises said second lateral type MOS FET, said third lateral type MOS FET, a second capacitor connected between the drain and the source of said third lateral type MOS FET, and a second resistor connected between the drain of vertical type MOS FET and the drain of said second lateral type MOS FET.

5.    A semiconductor integrated circuit device according to claim 1, wherein:

said vertical type MOS FET has the drain thereof connected to said load, the gate thereof connected to a switching control signal input terminal through a first resistor and the source thereof grounded, said first lateral type MOS FET having the drain thereof connected to the gate of said vertical type MOS FET and the source thereof grounded, said second lateral MOS FET having the source grounded;

said detection-control circuit comprises a comparator for comparing the gate voltage of said vertical type MOS FET with a reference voltage, an AND circuit to which are applied the output signal of said comparator and the drain voltage of said vertical type MOS FET, and a latch circuit for holding and imparting the output of said AND circuit to the gate of said first lateral type MOS FET; and

said comparator, said AND circuit and said latch circuit are constituted by a plurality of source-grounded lateral type MOS FET's including said second lateral type MOS FET, said plurality of lateral type MOS FET's being formed in the drain region of said vertical type MOS FET.

6.    A method of manufacturing a semiconductor integrated circuit device, comprising the steps of:

(a) providing an n type semiconductor substrate;

(b) forming an insulating thin layer on a main surface of said semiconductor substrate;

(c) implanting p type impurity ions into a first region, which is exposed at said main surface, of said semiconductor substrate through said insulating thin layer;

(d) forming a first and second conductor layer on said insulating thin layer;

(e) implanting p type impurity ions into said first region and a second region, which is exposed at said main surface and spaced apart from said first region, of said semiconductor substrate through said insulating thin layer;

(f) heating said semiconductor substrate to cause said p type impurity ions to be diffused, thereby forming a first and a second p type semiconductor region in said first and second regions in such a manner as to be exposed at said main surface, respectively;

(g) implanting n type impurity ions into said first and second p type semiconductor region through said insulating thin layer; and

(h) heating said semiconductor substrate to cause said n type impurity ions to be diffused, thereby forming a first and a second n type semiconductor region in said first p type semiconductor region in such a manner as to be exposed at said main surface and spaced apart from each other, while at the same time forming a third n type semiconductor region in such a manner as to exposed at said main surface.

7.    A method of manufacturing a semiconductor integrated circuit device according to calim 6, wherein said p type impurity ions comprise boron ions.

8.    A method of manufacturing a semiconductor integrated circuit device according to claim 6, wherein said n type impurity ions comprise phosphorus ions.

9.    A method of manufacturing a semiconductor integrated circuit device according to claim 6, wherein said first and second conductor layers are formed of polycrystalline silicon.

50

# Fig.1

PRIOR ART

VDD

ID 2

VD

D

VIN 3

IN

VG 1

G

CG S

# Fig.2

PRIOR ART

(a)
LOAD NORMAL

(b)
LOAD SHORTED

"H" ON
VIN "L" OFF

"H"
VG "L" VT

"H"
VD "L"

ID

# Fig. 3

PRIOR ART

VDD

ID

2

D

IN

6

G

1

CG

S

5

+
−

Vref

4

# Fig. 4

VDD

ID

RL

D

IN

R1

G

Q1

S

U

D

G

Q2

S

Fig. 5

3/11

0090280

# Fig. 6

# Fig. 7

(a)
LOAD NORMAL

(b)
LOAD SHORTED

## Fig. 8

## Fig. 9

# Fig.10

(a) LOAD NORMAL

(b) LOAD SHORTED

# Fig.11

# Fig.12

| (a) | (b) |
|-----|-----|
| LOAD NORMAL | LOAD SHORTED |

# Fig.13

# Fig.14

0090280

# Fig.14

# Fig.14

L

M

N